(19) Europäisches Patentamt
European Patent Office
Office européen des brevets

(11) **EP 2 721 369 B1**

(12) **FASCICULE DE BREVET EUROPEEN**

(45) Date de publication et mention de la délivrance du brevet:
**05.08.2015 Bulletin 2015/32**

(51) Int Cl.:
*G01R 27/26* (2006.01)  *G01R 17/10* (2006.01)
*H01L 27/06* (2006.01)  *H03K 3/012* (2006.01)
*G06F 3/044* (2006.01)

(21) Numéro de dépôt: **12737318.1**

(22) Date de dépôt: **08.06.2012**

(86) Numéro de dépôt international:
**PCT/FR2012/051289**

(87) Numéro de publication internationale:
**WO 2012/172240 (20.12.2012 Gazette 2012/51)**

(54) **DISPOSITIF POUR GENERER UNE DIFFERENCE DE TENSION ALTERNATIVE ENTRE DES POTENTIELS DE REFERENCE DE SYSTEMES ELECTRONIQUES**

VORRICHTUNG ZUR ERZEUGUNG EINES WECHSELSPANNUNGSUNTERSCHIEDES ZWISCHEN DEN REFERENZPOTENZIALEN ELEKTRONISCHER SYSTEME

DEVICE FOR GENERATING AN ALTERNATING VOLTAGE DIFFERENCE BETWEEN THE REFERENCE POTENTIALS OF ELECTRONIC SYSTEMS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.06.2011 FR 1155287**

(43) Date de publication de la demande:
**23.04.2014 Bulletin 2014/17**

(73) Titulaire: **Nanotec Solution**
**30900 Nîmes (FR)**

(72) Inventeurs:
• **BLONDIN, Christophe**
**F-30900 Nîmes (FR)**
• **NEEL, Christian**
**F-30900 Nîmes (FR)**
• **ROZIERE, Didier**
**F-30900 Nîmes (FR)**

(74) Mandataire: **Pontet Allano & Associes**
**Parc Les Algorithmes, Bâtiment Platon**
**CS 70003 Saint-Aubin**
**91192 Gif-sur-Yvette Cedex (FR)**

(56) Documents cités:
**EP-A1- 2 131 202     FR-A1- 2 693 555**
**FR-A1- 2 756 048     US-A- 3 656 065**
**US-A- 3 988 669**

## Description

### Domaine technique

La présente invention concerne un dispositif oscillateur à buffer séparé, permettant de générer une différence de tension alternative entre des potentiels de référence de systèmes électroniques.

Le domaine de l'invention est plus particulièrement mais de manière non limitative celui des dispositifs électroniques de mesure et de contrôle.

### Etat de la technique antérieure

De manière générale, les systèmes électroniques sont référencés par rapport à un potentiel de masse, qui peut être par exemple une référence en tension par rapport à laquelle sont fixées les tensions d'alimentation. Cette masse peut être ou non reliée à la terre.

Dans certains cas, il est nécessaire que des parties ou des sous-systèmes électroniques soient référencés à des potentiels différents du potentiel de masse du système global, et flottants ou variables par rapport à ce dernier. On rencontre ce cas de figure par exemple dans des systèmes de mesure, pour s'affranchir de perturbations électriques liées aux sources de bruit.

Parfois, la partie flottante n'est pas totalement séparée du reste du système par une isolation galvanique, mais elle est flottante ou variable uniquement dans une gamme de fréquences, ou autour d'une fréquence de travail.

Dans certains systèmes en particulier, un oscillateur est inséré entre le potentiel de référence de la partie flottante et le potentiel de masse. Il impose une différence de tension alternative entre ces deux potentiels de référence, faisant ainsi « flotter » le potentiel flottant par rapport au potentiel de masse (ou inversement).

On rencontre ce cas de figure par exemple dans le document FR 2 756 048 de Rozière qui divulgue un système de mesure capacitif. Le circuit de détection comprend une partie flottante dans une gamme de fréquences, dont le potentiel de référence oscille par rapport à la masse du système global à une fréquence d'oscillation.

Ce type de circuit pose le problème de l'interfaçage entre les parties soumises à des potentiels de référence différents, dont en particulier :

- la génération de la différence de tension alternative entre les potentiels de référence,
- l'alimentation de la partie flottante,
- le transfert des signaux de mesure et de commande, numériques ou analogiques, entre les parties à des potentiels de référence différents.

Comme expliqué précédemment, la différence de tension alternative entre les potentiels de référence peut être générée au moyen d'un oscillateur relié aux deux potentiels de référence, de telle sorte à imposer entre eux une différence de potentiel. En théorie, cet oscillateur peut être référencé de manière sensiblement équivalente au potentiel de masse ou au potentiel flottant.

Toutefois, il est souvent préférable que l'oscillateur soit référencé au potentiel flottant, car il est également utilisé comme oscillateur interne pour la partie flottante. On retrouve ce cas de figure notamment dans FR 2 756 048.

Le problème qui se pose alors est que cet oscillateur doit être en mesure de délivrer un courant (ou une puissance) suffisante, et donc doit être alimenté par une source d'alimentation électrique référencée au potentiel flottant de puissance suffisante.

Il est connu d'alimenter la partie flottante avec des sources d'alimentation référencées au potentiel de masse, plus facilement disponibles, en transmettant les tensions d'alimentation entre les parties référencées à la masse et les parties flottantes par l'intermédiaire de bobines d'inductance ou selfs de choc placées en série sur les lignes de telle sorte à présenter une impédance élevée à la fréquence d'oscillation du potentiel de référence flottant, ou par d'autres moyens tels que des convertisseurs DC/DC.

Des principes similaires peuvent d'ailleurs être également utilisés pour transmettre des signaux numériques ou analogiques.

Dans de nombreuses applications actuelles, les fonctions électroniques doivent être réalisées sous la forme de circuits électroniques intégrés avec un encombrement et une consommation électrique minimale. C'est particulièrement vrai pour les systèmes de mesure capacitifs qui sont de plus en plus utilisés pour réaliser des interfaces tactiles de systèmes portables (téléphones, ordinateurs, ...).

Dans ce contexte, les moyens connus pour transmettre les alimentations (et les signaux) entre les parties flottantes et non flottantes présentent des inconvénients gênants, tels qu'un encombrement et une consommation élevée.

Ces inconvénients sont particulièrement importants en ce qui concerne l'alimentation électrique des parties flottantes ou soumises à des potentiels de référence variables. En effet, les inductances (selfs de choc) et autres convertisseurs DC/DC sont particulièrement pénalisants pour la réalisation de circuits intégrés.

Il est donc important de limiter au maximum la consommation électrique de la partie flottante pour pouvoir recourir à des solutions d'alimentation moins pénalisantes en termes d'intégration. Or un oscillateur tel que réalisé dans les dispositifs de l'art antérieur est particulièrement gourmand en énergie et donc pénalisant de ce point de vue.

Un objet de la présente invention est de proposer un dispositif et un procédé pour générer une différence de tension alternative entre des potentiels électriques de référence, qui permette de minimiser la consommation électrique d'une partie à un potentiel de référence variable.

Un autre objet de la présente invention est de proposer un dispositif et un procédé pour générer une différence de tension alternative entre des potentiels électriques de référence, qui permette la mise en oeuvre de solutions pour alimenter une partie à un potentiel de référence variable qui soient peu pénalisantes en termes d'intégration de composants.

**Exposé de l'invention**

Cet objectif est atteint avec un dispositif pour générer une différence de tension alternative entre un premier et un second potentiels de référence, comprenant un oscillateur électriquement référencé au premier potentiel de référence,
caractérisé en ce qu'il comprend en outre un dispositif suiveur/amplificateur de tension électriquement référencé au second potentiel de référence et ayant une entrée reliée à l'oscillateur et une sortie reliée au premier potentiel de référence de telle sorte à pouvoir imposer entre lesdits premiers et seconds potentiels de référence une différence de tension alternative dépendant du signal généré par l'oscillateur.

Bien entendu, le terme « relié » doit être interprété dans le sens où des composants reliés entre eux peuvent être reliés directement, au travers d'une liaison électrique directe, ou reliés par l'intermédiaire de composants électriques ou électroniques additionnels.

Le dispositif suiveur/amplificateur de tension peut comprendre un amplificateur opérationnel, configuré en suiveur de tension, ou de gain quelconque.

Suivant des modes de réalisation, le dispositif selon l'invention peut comprendre en outre :

- un diviseur de tension inséré entre l'oscillateur et l'entrée du dispositif suiveur/amplificateur de tension ;
- au moins une résistance insérée entre l'oscillateur et l'entrée du dispositif suiveur/amplificateur de tension, et au moins une résistance insérée entre l'entrée du dispositif suiveur/amplificateur de tension et le second potentiel de référence.

Le dispositif selon l'invention peut comprendre en outre des moyens de transfert d'alimentation aptes à générer en une sortie d'alimentation une alimentation électrique référencée au premier potentiel de référence, à partir d'une source d'alimentation primaire référencée au second potentiel de référence.

Il peut comprendre en outre un circuit électrique reliant les bornes de la source d'alimentation primaire au travers de la sortie du dispositif suiveur/amplificateur de tension.

Cette configuration est possible car le dispositif suiveur/amplificateur de tension piloté par l'oscillateur se comporte sensiblement comme un générateur de tension parfait, appelé également générateur de Thévenin. Il permet d'imposer une différence de tension alternative entre les premiers et seconds potentiels de référence, ce qui permet de les maintenir variables ou flottants l'un par rapport à l'autre, tout en présentant une impédance très faible pour le courant d'alimentation. Ce résultat ne pourrait pas être obtenu sans la présence du dispositif suiveur/amplificateur de tension piloté par l'oscillateur.

Suivant un mode de réalisation, le dispositif selon l'invention peut comprendre en outre des moyens de transfert d'alimentation agencés en élévateur de tension à découpage, comprenant :

- une inductance reliée à une source d'alimentation primaire sensiblement continue,
- un commutateur relié, respectivement, à l'inductance et au second potentiel de référence, de telle sorte à pouvoir ouvrir et fermer le circuit de manière cyclique (périodique ou non périodique),
- une diode reliée, respectivement, à l'inductance, et à une sortie d'alimentation, et
- des moyens de filtrage, comprenant au moins une capacité de filtrage reliée à la sortie d'alimentation et au premier potentiel de référence, respectivement.

Suivant un autre mode de réalisation, le dispositif selon l'invention peut comprendre en outre des moyens de transfert d'alimentation agencés en redresseur élévateur de tension, comprenant :

- une capacité de charge reliée à une source d'alimentation primaire alternative bipolaire,
- une première diode reliée, respectivement, au premier potentiel de référence et à la capacité de charge,
- une seconde diode reliée, respectivement, à la capacité de charge et à la sortie d'alimentation, et
- des moyens de filtrage comprenant au moins une capacité de filtrage reliée à la sortie d'alimentation et au premier potentiel de référence, respectivement.

Le dispositif selon l'invention peut être réalisé selon des technologies d'électronique intégrée.

Suivant un autre aspect, il est proposé un système électronique de mesure capacitive comprenant un premier sous-système référencé électriquement à un potentiel de garde, un second sous-système référencé électriquement à un potentiel de masse, et un oscillateur référencé audit potentiel de garde,
lequel système comprenant en outre un dispositif selon l'invention pour imposer entre lesdits potentiels de masse et de garde une différence de tension alternative dépendant du signal généré par l'oscillateur.

Le système électronique de mesure capacitive selon l'invention peut comprendre en outre un amplificateur de charge référencé au potentiel de garde et alimenté par des moyens de transfert d'alimentation selon l'invention.

Suivant encore un autre aspect, il est proposé un procédé pour générer une différence de tension alternative entre un premier et un second potentiel de référence, comprenant une étape de génération d'un signal au moyen d'un oscillateur électriquement référencé au premier potentiel de référence,

lequel procédé comprenant en outre une étape d'amplification dudit signal, au moyen d'un dispositif suiveur/amplificateur de tension électriquement référencé au second potentiel de référence et ayant une entrée reliée à l'oscillateur et une sortie reliée au premier potentiel de référence, de telle sorte à imposer entre lesdits premiers et seconds potentiels de référence une différence de tension alternative dépendant dudit signal généré par l'oscillateur.

**Description des figures et modes de réalisation**

D'autres avantages et particularités de l'invention apparaîtront à la lecture de la description détaillée de mises en oeuvre et de modes de réalisation nullement limitatifs, et des dessins annexés suivants :

- la figure 1 illustre un mode de réalisation représentatif de l'art antérieur de dispositif pour générer une différence de tension alternative entre des potentiels de référence de systèmes électroniques,
- la figure 2 illustre un premier mode de réalisation de dispositif selon l'invention pour générer une différence de tension alternative entre des potentiels de référence de systèmes électroniques,
- la figure 3 illustre un second mode de réalisation de dispositif selon l'invention pour générer une différence de tension alternative entre des potentiels de référence de systèmes électroniques,
- la figure 4 illustre un mode de réalisation d'un système électronique de mesure capacitive mettant en oeuvre un dispositif selon l'invention pour générer une différence de tension alternative entre les potentiels de référence de différents sous-systèmes électroniques,
- la figure 5 illustre un mode de réalisation de dispositif selon l'invention comprenant des moyens de transfert d'alimentation,
- la figure 6 illustre un premier mode de réalisation de moyens de transfert d'alimentation,
- la figure 7 illustre un second mode de réalisation de moyens de transfert d'alimentation,

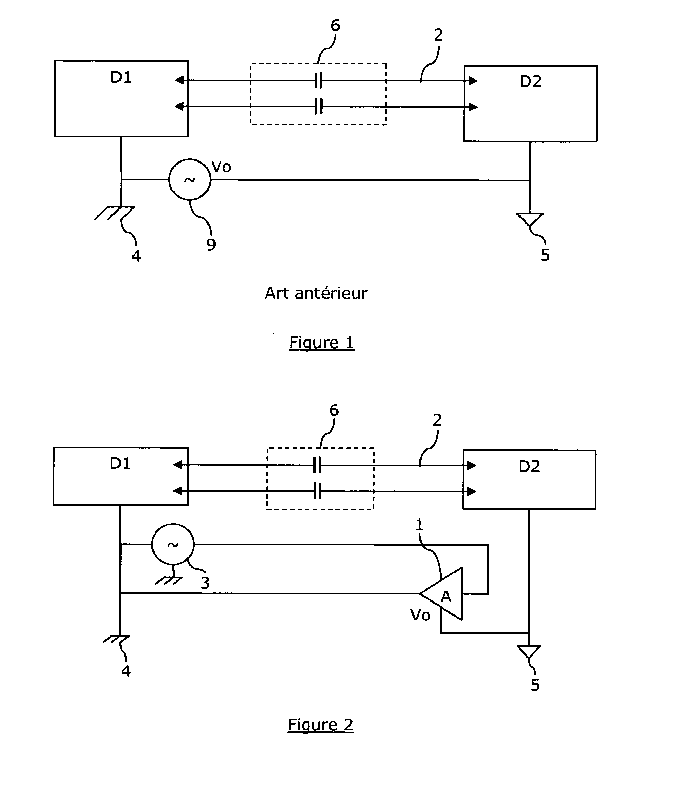

En référence à la figure 1, le contexte de l'invention est celui des applications ou des systèmes électroniques nécessitant l'interconnexion de systèmes électroniques D1, D2 dont les potentiels de référence 4, 5 sont séparés par une différence de potentiel alternative périodique **Vo**. Cette différence de potentiel **Vo** peut être de toute forme, par exemple sinusoïdale, carré, ou triangulaire.

Cette situation se retrouve, par exemple, dans des systèmes de mesure électroniques.

Suivant une configuration fréquente mais non limitative, le système électronique comprend :

- un système D2 référencé électriquement à la masse ou à la terre 5, qui comprend les moyens d'alimentation électrique de l'ensemble, ou est relié à un réseau d'alimentation électrique ;
- un autre système électronique D1 référencé électriquement à un potentiel de référence variable 4, qui comprend par exemple des moyens électroniques de mesure ou de détection à grande sensibilité et/ou à faible bruit.

Suivant une configuration représentative de l'art antérieur présentée à la figure 1, la différence de potentiel alternative périodique **Vo** est générée par une source d'excitation 9 de tension alternative qui relie (directement ou indirectement) la masse 5 et la référence flottante ou variable 4, de telle sorte à faire osciller la tension de référence variable 4 par rapport à la masse 5.

Les systèmes électroniques D1 et D2 sont reliés par des liaisons électriques 2 qui permettent de faire transiter par exemple des signaux numériques ou analogiques. Ces liaisons électriques 2 sont pourvues de moyens de découplage 6 pour assurer une isolation entre les potentiels de référence 4 et 5, au moins dans une gamme de fréquence. Ces moyens de découplage 6 peuvent comprendre par exemple des inductances insérées en série sur les lignes ou des amplificateurs opérationnels différentiels. Ils peuvent également comprendre des capacités, ce qui constitue une solution avantageuse en termes d'intégration dans un contexte de réalisation de circuits sous la forme de circuits intégrés, ou des amplificateurs opérationnels différentiels.

Le système électronique D1 au potentiel de référence variable 4 peut être alimenté en transférant des alimentations électriques du système au potentiel de masse D2, par exemple au travers de liaisons électriques 2 pourvues de moyens de découplage 6. Dans ce cas, ces moyens de découplage 6 doivent pouvoir laisser passer de la puissance à basse fréquence, ce qui implique l'emploi de composants tels que des inductances ou des transformateurs, pénalisants en termes d'intégration dans des circuits intégrés.

Il est également connu d'utiliser des convertisseurs DC/DC, mais qui sont également pénalisants en termes d'encombrement dans des circuits intégrés.

L'alimentation du système électronique D1 au potentiel de référence variable 4 représente donc des contraintes particulières pour une réalisation sous forme de circuit intégré ou d'ASICs (en anglais : « Application Specific Integrated Circuit »).

Afin de limiter ces contraintes, il est nécessaire de minimiser la puissance électrique consommée par le système électronique D1 au potentiel de référence variable 4, ce qui permet de mettre en oeuvre des schémas d'alimentation avec des composants plus aisément intégrables.

De ce point de vue, la source d'excitation 9 consomme souvent une puissance importante, car elle doit être en mesure de fournir un courant adapté à son impédance de charge, représentée notamment par les moyens de découplage 6 en parallèle.

Dans le but de générer le potentiel variable 4, cette source d'excitation 9 peut être indifféremment référencée à ce potentiel de référence variable 4 ou au potentiel de masse 5. Elle est alors alimentée, respectivement, par une alimentation référencée au potentiel de référence variable 4 ou au potentiel de masse 5.

Toutefois, il est souvent préférable de mettre en oeuvre une source d'excitation 9 référencée au potentiel de référence variable 4. C'est notamment le cas lorsque cette source d'excitation 9 est également utilisée comme oscillateur pour la partie flottante (pour une détection synchrone, ou comme signal d'excitation par exemple). Cette configuration se retrouve par exemple dans les configurations décrites dans FR 2 756 048.

En référence à la figure 2, un objet de l'invention est précisément de proposer un dispositif pour générer la différence de tension alternative **Vo** entre les potentiels de référence 4, 5 à partir d'un oscillateur 3 référencé au potentiel variable 4, tout en minimisant la consommation électrique de cette partie flottante.

Le dispositif selon l'invention comprend un oscillateur 3 référencé au potentiel variable 4. Cet oscillateur génère un signal alternatif qui est utilisable comme signal d'excitation ou d'horloge dans le système électronique D1. Ce signal peut être de toute forme (par exemple sinusoïdale, carrée, ou triangulaire) en fonction des applications.

Le dispositif selon l'invention comprend également un buffer 1 référencé au potentiel de masse 5. Ce buffer 1 comprend un amplificateur ou un suiveur de tension (à gain défini) réalisé sur la base de transistors agencés sous la forme d'amplificateur(s) opérationnel(s). La sortie de l'oscillateur 3 est reliée à l'entrée du buffer 1. La sortie du buffer 1 est reliée au potentiel de référence variable 4.

Le buffer 1 délivre en sortie un signal d'excitation **Vo**. Comme sa référence électrique interne (ou celle de son alimentation) est le potentiel de masse 5, il se comporte comme une source de tension délivrant un signal **Vo** ou en d'autres termes générant une différence de tension alternative **Vo** entre la masse 5 et le potentiel de référence variable 4.

En procédant de cette manière, on obtient les avantages d'un oscillateur 3 référencé au potentiel variable 4, mais dont la consommation électrique est minimisée. En effet, l'essentiel de la puissance nécessaire pour exciter le potentiel de référence variable 4 est fournie par le buffer 1 qui est référencé au potentiel de masse 5.

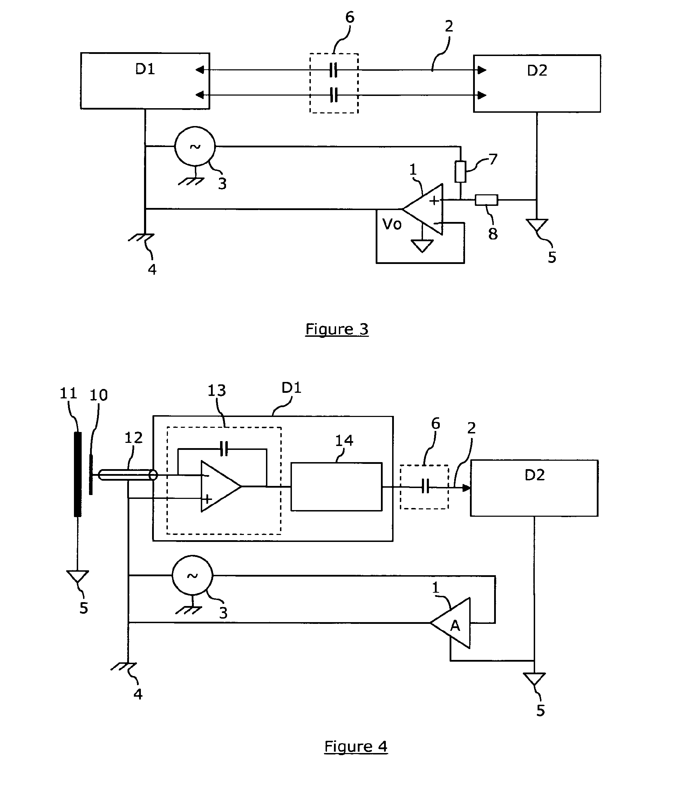

La figure 3 présente un exemple de mode de réalisation dans lequel le buffer 1 est réalisé sous la forme d'un amplificateur opérationnel câblé en suiveur de tension.

La sortie de l'oscillateur 3 est reliée à l'entrée du buffer 1 au travers d'un pont diviseur résistif comprenant une résistance 7 insérée entre la sortie de l'oscillateur 3 et l'entrée du buffer 1, et une résistance 8 insérée entre l'entrée du buffer 1 et le potentiel de masse 5.

En supposant que la résistance 7 a une valeur **R**, que la résistance 8 a une valeur **G** x **R** et que l'oscillateur 3 délivre une tension **Ve**, compte tenu du fait que la tension à l'entrée du buffer 1 est sensiblement égale à la tension à sa sortie **Vo** (puisque c'est un suiveur de tension), on a :

$$\textbf{Vo} = \textbf{G} \,/\, (1+\textbf{G})\,(\textbf{Vo} + \textbf{Ve}),$$

Et donc

$$\textbf{Vo} = \textbf{G} \times \textbf{Ve}.$$

On a ainsi introduit un gain **G** dans la boucle qui permet d'utiliser un oscillateur 3 délivrant une tension Ve très inférieure à la différence de tension **Vo** nécessaire entre les potentiels de référence 4, 5. Cela permet notamment de minimiser encore la consommation de l'oscillateur 3.

Des dispositifs selon l'invention peuvent être avantageusement mis en oeuvre dans une grande variété de systèmes électroniques qui nécessitent des masses 4, 5 à des potentiels différents mais pas nécessairement isolés.

Le dispositif selon l'invention est particulièrement bien adapté pour réaliser l'excitation de la partie flottante d'un système de mesure capacitif en pont flottant tel que décrit par exemple dans le document FR 2 756 048 de Rozière. En effet, dans cette application, le circuit de détection comprend une partie flottante dont le potentiel de référence, appelé potentiel de garde, oscille par rapport à la masse du système global, ou à la terre. La différence de potentiel alternative entre le potentiel de garde et la masse est générée par un oscillateur référencé au potentiel de garde.

La figure 4 présente un exemple de configuration d'un système de mesure capacitif en pont flottant tel que décrit dans le document FR 2 756 048, en mode de mesure de capacité, auquel a été ajouté un dispositif d'excitation selon l'invention.

Un tel système de mesure capacitif permet de mesurer une information de capacité entre au moins une électrode de mesure 10 et une cible 11 à un potentiel relié au potentiel de masse 5.

Il comprend une partie flottante D1, référencée à un potentiel de garde 4 oscillant par rapport au potentiel de masse 5, et une partie D2 référencée au potentiel de masse 5.

Un oscillateur 3 référencé au potentiel de garde 4 et un buffer 1 référencé au potentiel de masse 5 assure l'excitation du potentiel de garde 4 conformément à l'invention.

Une électrode de garde 12 protège l'électrode de mesure 10. Etant au même potentiel que cette dernière, elle évite l'apparition de capacités parasites. L'électrode de mesure 10 est reliée à un amplificateur de charge 13 qui permet d'en mesurer la capacité.

Suivant les applications, la partie flottante de l'électronique D1 peut comprendre d'autres étages de traitement du signal 14, afin par exemple de délivrer un signal représentatif d'une distance entre l'électrode de mesure 10 et la cible 11. Le système peut en outre comprendre plusieurs électrodes 10 de toutes géométries. Il peut également comprendre un scrutateur inséré entre les électrodes 10 et l'amplificateur de charge 13, et permettant de mesurer séquentiellement la capacité de ces électrodes 10.

Les parties D1 et D2 sont reliées par des liaisons électriques 2 qui permettent de faire transiter les signaux numériques ou analogiques. Ces liaisons électriques 2 sont pourvues de moyens de découplage 6 (par exemple des capacités, facilement intégrables) pour assurer une isolation entre les potentiels de masse et de garde, au moins dans une gamme de fréquence.

Un système de mesure capacitif en pont flottant tel que décrit à la figure 4 permet notamment de réaliser des interfaces tactiles ou sans contact pour des appareils tels que des téléphones portables (« smartphones ») des tablettes ou des ordinateurs. Les électrodes 10 peuvent être des électrodes transparentes, par exemple en ITO (oxyde d'indium dopé à l'étain), déposées sur un écran d'affichage ou une dalle tactile. Elles sont alors utilisées pour détecter l'approche et/ou le contact d'un objet de commande 11 tel qu'un doigt.

Dans ce cas, l'intégration de l'électronique sous forme de circuits intégrés ou d'ASICs d'encombrement minimum est fondamentale et l'invention prend toute son importance.

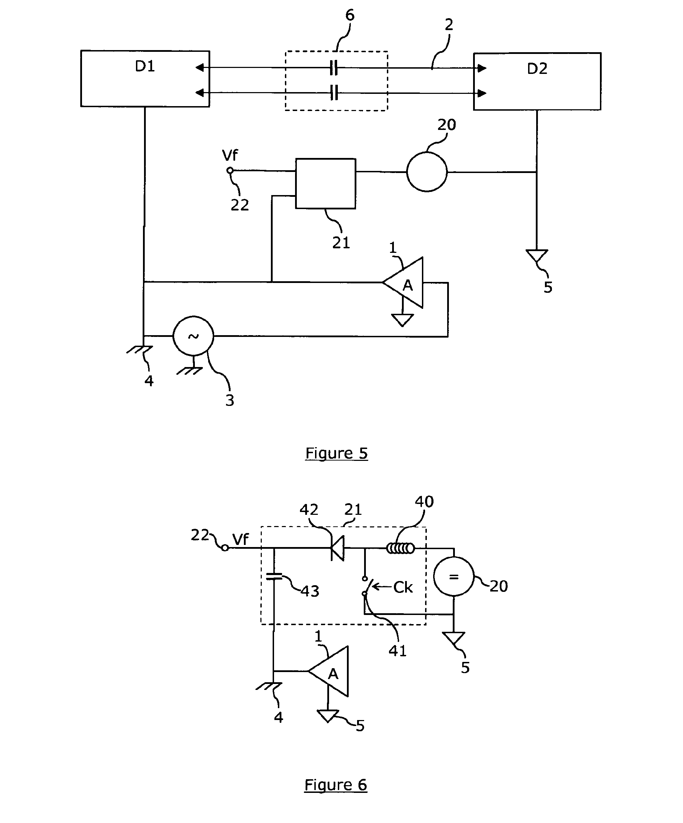

En référence à la figure 5, un objet de l'invention est également de proposer des solutions pour générer des sources d'alimentation **Vf** référencées au potentiel de référence variable 4 qui soient favorables en termes d'intégration dans des circuits intégrés, en exploitant précisément au moins l'un des avantages fournis par l'invention, soit :

- une minimisation de la consommation de l'oscillateur 3 référencé au potentiel variable 4,
- la possibilité d'exploiter la sortie du buffer 1, qui se comporte comme une source de tension à basse impédance, comme chemin de retour entre le potentiel de référence variable 4 et le potentiel de masse 5 pour une source d'alimentation primaire 20 référencée au potentiel de masse 5.

Les sources d'alimentation selon l'invention comprennent donc, de manière schématique :

- une source d'alimentation primaire 20, référencée au potentiel de masse 5, et
- des moyens de transfert d'alimentation 21, qui sont reliés en entrée à la source d'alimentation primaire 20 et dont la sortie 22 est une source d'alimentation **Vf** référencée au potentiel de référence variable 4.

Si nécessaire, le chemin de retour vers la source 20 (ou le potentiel de masse 5 auquel elle est reliée) s'effectue au travers de la sortie du buffer 1.

Le buffer 1 piloté par l'oscillateur 3, permet en effet de réaliser un retour du circuit d'alimentation par une liaison entre le potentiel de référence variable 4 et le potentiel de masse 5, sans court-circuiter ces potentiels de références aux fréquences du signal d'excitation de l'oscillateur 3. Cet effet est obtenu comme expliqué précédemment grâce au fonctionnement en générateur de Thévenin du buffer 1 piloté par l'oscillateur 3, qui impose le signal d'excitation entre les potentiels de référence variable 4 et de masse 5, tout en ayant une impédance faible.

La source d'alimentation **Vf** selon l'invention peut en particulier être utilisée pour alimenter l'oscillateur 3, et, dans le système de mesure capacitif de la figure 3, par exemple l'amplificateur de charge 13.

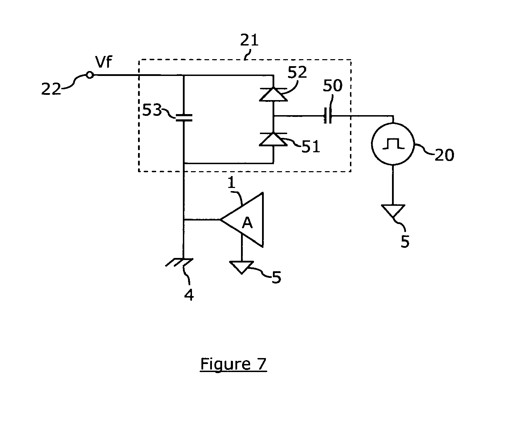

Les figures 6 et 7 présentent des exemples non limitatifs de sources d'alimentation **Vf** selon l'invention.
La figure 6 présente un exemple de mode de réalisation d'une source d'alimentation selon l'invention, selon un principe d'élévateur de tension à découpage.

Elle comprend une inductance 40 reliée à une source d'alimentation primaire 20 sensiblement continue. Un commutateur électronique 41 actionné par un signal périodique ouvre et ferme périodiquement le circuit de l'inductance 40 et de la source primaire 20, ce qui a pour effet de provoquer des variations de tension aux bornes de l'inductance 40 en fonction de la variation du courant qui la traverse. Une diode 42 élimine les alternances négatives.

Suivant un principe applicable à tous les types de sources d'alimentation selon l'invention, la source comprend en outre un filtre de lissage comprenant une capacité 43 connectée à sa sortie, entre le potentiel de référence variable 4 et la sortie d'alimentation 22 de la tension **Vf**. La fonction de lissage peut également être effectuée par des éléments équivalents, tels que des capacités parasites et/ou des impédances d'entrée de composants, et dans la mesure de ce qui est nécessaire pour les besoins de l'utilisation de la tension d'alimentation **Vf**.

La figure 7 présente un autre exemple de mode de réalisation d'une source d'alimentation selon l'invention, selon un principe de redresseur élévateur de tension de Schenkel. Cette source d'alimentation comprend :

- une capacité de charge 50 reliée à une source d'alimentation primaire 20 alternative bipolaire,
- une première diode 51 reliée, respectivement, au premier potentiel de référence 4 et à la capacité de charge 50,
- une seconde diode 52 reliée, respectivement, à la capacité de charge 50 et à la sortie d'alimentation 22,
- des moyens de filtrage comprenant au moins une capacité de filtrage 53 reliée à la sortie d'alimentation 22 et au premier potentiel de référence 4, respectivement.

Suivant des variantes de l'invention,

- le signal de l'oscillateur 3 peut être sinusoïdal, carré ou de toute autre forme ;
- l'oscillateur 3 peut être un oscillateur bipolaire, symétrique, délivrant un signal compris entre une valeur positive et une valeur négative, ou unipolaire, asymétrique, délivrant un signal compris entre une valeur maximale ou minimale et le potentiel de référence 5 ;
- l'oscillateur 3 peut être de type analogique ou numérique, par exemple à synthèse numérique directe (DDS) ;
- le buffer 1 peut comprendre tous types de montages électroniques permettant de réaliser un amplificateur ou un suiveur de tension, avec un gain unitaire, une amplification ou une atténuation ;
- tous moyens de transfert d'alimentation 21 permettant de générer une ou plusieurs tension(s) d'alimentation **Vf** référencée(s) au potentiel variable 4 peuvent être mis en oeuvre dans le cadre de l'invention. Ils peuvent comprendre, de manière non limitative, des systèmes à transfert de charge, à pompe de charge, élévateur, atténuateur de tension, réalisée par association de capacités et de diodes ou par tous autres moyens ;

L'invention peut également être mise en oeuvre dans des applications très variées, parmi lesquelles on peut citer notamment :

- tous types d'électronique capacitive à pont flottant, avec tous types de traitement de signal tels que des filtres, des démodulations synchrones analogiques ou numériques, des convertisseurs analogiques/numériques (ADC), des dispositifs d'asservissement pour réaliser des ponts de mesure de capacité **C** ou d'inverse de la capacité 1/**C**, des commande de commutateurs pour scruter séquentiellement plusieurs électrodes, ... ;
- tous systèmes de mesure capacitifs ou basés sur un autre principe physique comprenant une partie à un potentiel de référence variable;

- des applications où il est nécessaire de limiter des courants parasites alternatifs entre des systèmes et assures une protection électromagnétique (CEM) ;
- toutes applications nécessitant l'interconnexion de systèmes électroniques dont toutes les tensions de référence ou une partie des tensions de référence sont flottantes avec des différences de potentiels alternatives ;
- tous systèmes électroniques comprenant des parties référencées à des potentiels différents, excités l'un relativement à l'autre par un oscillateur, ces potentiels de référence pouvant être tous flottants ou variables par rapport à une masse ou une terre, et l'oscillateur pouvant être référencé à un potentiel relié à une masse ou une terre ou flottant par rapport à une masse ou une terre.

Bien sûr, l'invention n'est pas limitée aux exemples qui viennent d'être décrits et de nombreux aménagements peuvent être apportés à ces exemples sans sortir du cadre de l'invention.

## Revendications

1.  Dispositif pour générer une différence de tension alternative (**Vo**) entre un premier et un second potentiels de référence (4, 5), comprenant un oscillateur (3) électriquement référencé au premier potentiel de référence (4),
    **caractérisé en ce qu'**il comprend en outre un dispositif suiveur/amplificateur de tension (1), électriquement référencé au second potentiel de référence (5) et ayant une entrée reliée à l'oscillateur (3) et une sortie reliée au premier potentiel de référence (4) de telle sorte à pouvoir imposer entre lesdits premiers et seconds potentiels de référence (4, 5) une différence de tension alternative (**Vo**) dépendant du signal généré par l'oscillateur (3).

2.  Dispositif selon la revendication 1, **caractérisé en ce que** le dispositif suiveur/amplificateur de tension (1) comprend un amplificateur opérationnel.

3.  Dispositif selon l'une des revendications 1 ou 2, **caractérisé en ce qu'**il comprend en outre un diviseur de tension inséré entre l'oscillateur (3) et l'entrée du dispositif suiveur/amplificateur de tension (1).

4.  Dispositif selon la revendication 3, **caractérisé en ce qu'**il comprend en outre au moins une résistance (7) insérée entre l'oscillateur (3) et l'entrée du dispositif suiveur/amplificateur de tension (1), et au moins une résistance (8) insérée entre l'entrée du dispositif suiveur/amplificateur de tension (1) et le second potentiel de référence (5).

5.  Dispositif selon l'une des revendications précédentes, **caractérisé en ce qu'**il comprend en outre des moyens de transfert d'alimentation (21) aptes à générer en une sortie d'alimentation (22) une alimentation électrique (**Vf**) référencée au premier potentiel de référence (4), à partir d'une source d'alimentation primaire (20) référencée au second potentiel de référence (5).

6. Dispositif selon la revendication 5, **caractérisé en ce qu'**il comprend en outre un circuit électrique reliant les bornes de la source d'alimentation primaire (20) au travers de la sortie du dispositif suiveur/amplificateur de tension (1).

7. Dispositif selon l'une des revendications 5 ou 6, **caractérisé en ce qu'**il comprend en outre des moyens de transfert d'alimentation (21) agencés en élévateur de tension à découpage, comprenant :

    - une inductance (40) reliée à une source d'alimentation primaire (20) sensiblement continue,
    - un commutateur (41) relié, respectivement, à l'inductance (40) et au second potentiel de référence (5), de telle sorte à pouvoir ouvrir et fermer le circuit de manière cyclique,
    - une diode (21) reliée, respectivement, à l'inductance (40), et à une sortie d'alimentation (22), et
    - des moyens de filtrage (43), comprenant au moins une capacité de filtrage (43) reliée à la sortie d'alimentation (22) et au premier potentiel de référence (4), respectivement.

8. Dispositif selon l'une des revendications 5 ou 6, **caractérisé en ce qu'**il comprend en outre des moyens de transfert d'alimentation (21) agencés en redresseur élévateur de tension, comprenant :

    - une capacité de charge (50) reliée à une source d'alimentation primaire (20) alternative bipolaire,
    - une première diode (51) reliée, respectivement, au premier potentiel de référence (4) et à la capacité de charge (50),
    - une seconde diode (52) reliée, respectivement, à la capacité de charge (50) et à la sortie d'alimentation (22), et
    - des moyens de filtrage comprenant au moins une capacité de filtrage (53) reliée à la sortie d'alimentation (22) et au premier potentiel de référence (4), respectivement.

9. Dispositif selon l'une des revendications précédentes, **caractérisé en ce qu'**il est réalisé selon des technologies d'électronique intégrée.

10. Système électronique de mesure capacitive comprenant un premier sous-système (D1) référencé électriquement à un potentiel de garde (4), un second sous-système (D2) référencé électriquement à un potentiel de masse (5), et un oscillateur (3) référencé audit potentiel de garde (4), **caractérisé en ce qu'**il comprend en outre un dispositif selon l'une quelconque des revendications précédentes pour imposer entre lesdits potentiels de masse (5) et de garde (4) une différence de tension alternative (Vo) dépendant du signal généré par l'oscillateur (3).

11. Système électronique de mesure capacitive selon la revendication 10, **caractérisé en ce qu'**il comprend en outre un amplificateur de charge (13) référencé au potentiel de garde (4) et alimenté par des moyens de transfert d'alimentation (21) selon l'une quelconque des revendications 5 à 9.

12. Procédé pour générer une différence de tension alternative (**Vo**) entre un premier et un second potentiel de référence (4, 5), comprenant une étape de génération d'un signal au moyen d'un oscillateur (3) électriquement référencé au premier potentiel de référence (4), **caractérisé en ce qu'**il comprend en outre une étape d'amplification dudit signal, au moyen d'un dispositif suiveur/amplificateur de tension (1) électriquement référencé au second potentiel de référence (5) et ayant une entrée reliée à l'oscillateur (3) et une sortie reliée au premier potentiel de référence (4), de telle sorte à imposer entre lesdits premiers et seconds potentiels de référence (4, 5) une différence de tension alternative (**Vo**) dépendant dudit signal généré par l'oscillateur (3).

**Patentansprüche**

1. Vorrichtung zum Erzeugen einer Wechselspannungsdifferenz (Vo) zwischen einem ersten und einem zweiten Bezugspotential (4, 5), umfassend einen Oszillator (3), der elektrisch auf das erste Bezugspotential (4) bezogen ist, **dadurch gekennzeichnet, dass** sie ferner eine Spannungsfolge-/- verstärkungsvorrichtung (1) umfasst, die elektrisch auf das zweite Bezugspotential (5) bezogen ist und einen mit dem Oszillator (3) verbundenen Eingang sowie einen mit dem ersten Bezugspotential (4) verbundenen Ausgang aufweist, derart, dass zwischen dem ersten und dem zweiten Bezugspotential (4, 5) eine von dem durch den Oszillator (3) erzeugten Signal abhängige Wechselspannungsdifferenz (Vo) aufgedrückt werden kann.

2. Vorrichtung nach Anspruch 1, **dadurch gekennzeichnet, dass** die Spannungsfolge-/-verstärkungsvorrichtung (1) einen Operationsverstärker umfasst.

**3.** Vorrichtung nach einem der Ansprüche 1 oder 2, **dadurch gekennzeichnet, dass** sie ferner einen Spannungsteiler, der zwischen dem Oszillator (3) und dem Eingang der Spannungsfolge-/-verstärkungsvorrichtung (1) eingefügt ist, umfasst.

**4.** Vorrichtung nach Anspruch 3, **dadurch gekennzeichnet, dass** sie ferner wenigstens einen Widerstand (7), der zwischen dem Oszillator (3) und dem Eingang der Spannungsfolge-/-verstärkungsvorrichtung (1) eingefügt ist, sowie wenigstens einen Widerstand (8), der zwischen dem Eingang der Spannungsfolge-/- verstärkungsvorrichtung (1) und dem zweiten Bezugspotential (5) eingefügt ist, umfasst.

**5.** Vorrichtung nach einem der vorhergehenden Ansprüche, **dadurch gekennzeichnet, dass** sie ferner Versorgungsübertragungsmittel (21) umfasst, die geeignet sind, an einem Versorgungsausgang (22) eine auf das erste Bezugspotential (4) bezogene Stromversorgung (Vf) mittels einer auf das zweite Bezugspotential (5) bezogenen primären Versorgungsquelle (20) zu erzeugen.

**6.** Vorrichtung nach Anspruch 5, **dadurch gekennzeichnet, dass** sie ferner einen elektrischen Schaltkreis, welcher die Anschlüsse der primären Versorgungsquelle (20) über den Ausgang der Spannungsfolge-/-verstärkungsvorrichtung (1) verbindet, umfasst.

**7.** Vorrichtung nach einem der Ansprüche 5 oder 6, **dadurch gekennzeichnet, dass** sie ferner Versorgungsübertragungsmittel (21) umfasst, die als schaltender Spannungserhöher eingerichtet sind, mit:

- einer Drossel (40), die mit einer primären, im Wesentlichen Gleichstromversorgungsquelle (20) verbunden ist,
- einem Schalter (41), der mit der Drossel (40) bzw. mit dem zweiten Bezugspotential (5) verbunden ist, derart, dass er den Kreis zyklisch öffnen und schließen kann,
- einer Diode (21), die mit der Drossel (40) bzw. mit einem Versorgungsausgang (22) verbunden ist, und
- Filtermitteln (43), die wenigstens eine Filterkapazität (43), welche mit dem Versorgungsausgang (22) bzw. mit dem ersten Bezugspotential (4) verbunden ist, umfassen.

**8.** Vorrichtung nach einem der Ansprüche 5 oder 6, **dadurch gekennzeichnet, dass** sie ferner Versorgungsübertragungsmittel (21) umfasst, die als spannungserhöhender Gleichrichter eingerichtet sind, mit:

- einer Ladekapazität (50), die mit einer bipolaren primären Wechselstromversorgungsquelle (20) verbunden ist,
- einer ersten Diode (51), die mit dem ersten Bezugspotential (4) bzw. mit der Ladekapazität (50) verbunden ist,
- einer zweiten Diode (52), die mit der Ladekapazität (50) bzw. mit dem Versorgungsausgang (22) verbunden ist, und
- Filtermitteln, die wenigstens eine Filterkapazität (53), welche mit dem Versorgungsausgang (22) bzw. mit dem ersten Bezugspotential (4) verbunden ist, umfassen.

**9.** Vorrichtung nach einem der vorhergehenden Ansprüche, **dadurch gekennzeichnet, dass** sie nach Technologien integrierter Elektronik ausgebildet ist.

**10.** Elektronisches System zur kapazitiven Messung, umfassend ein erstes Teilsystem (D1), das elektrisch auf ein Schutzpotential (4) bezogen ist, ein zweites Teilsystem (D2), das elektrisch auf ein Massepotential (5) bezogen ist, sowie einen Oszillator (3), der auf das Schutzpotential (4) bezogen ist, **dadurch gekennzeichnet, dass** es ferner eine Vorrichtung nach einem der vorhergehenden Ansprüche umfasst, um zwischen dem Massepotential (5) und dem Schutzpotential (4) eine von dem durch den Oszillator (3) erzeugten Signal abhängige Wechselspannungsdifferenz (Vo) aufzudrücken.

**11.** Elektronisches System zur kapazitiven Messung nach Anspruch 10, **dadurch gekennzeichnet, dass** es ferner einen Ladungsverstärker (13) umfasst, der auf das Schutzpotential (4) bezogen ist und durch Versorgungsübertragungsmittel (21) nach einem der Ansprüche 5 bis 9 gespeist wird.

**12.** Verfahren zum Erzeugen einer Wechselspannungsdifferenz (Vo) zwischen einem ersten und einem zweiten Bezugspotential (4, 5), umfassend einen Schritt zum Erzeugen eines Signals mittels eines Oszillators (3), der elektrisch auf das erste Bezugspotential (4) bezogen ist, **dadurch gekennzeichnet, dass** es ferner einen Schritt zur Verstärkung des Signals mittels einer Spannungsfolge-/-verstärkungsvorrichtung (1) umfasst, die elektrisch auf das zweite Bezugspotential (5) bezogen ist und einen mit dem Oszillator (3) verbundenen Eingang sowie einen mit dem ersten Bezugspotential (4) verbundenen Ausgang aufweist, derart, dass zwischen dem ersten und dem zweiten Bezugspotential (4, 5) eine von dem durch den Oszillator (3) erzeugten Signal abhängige Wechselspannungsdifferenz (Vo) aufgedrückt wird.

**Claims**

1. Device for generating an alternating voltage difference (**Vo**) between a first and a second reference potential (4, 5), comprising an oscillator (3) electrically referenced to the first reference potential (4), **characterized in that** it comprises moreover a voltage follower/amplifier device (1) electrically referenced to the second reference potential (5) and having an input connected to the oscillator (3) and an output connected to the first reference potential (4) in such a way as to be able to impose an alternating voltage difference (**Vo**), which depends on the signal generated by the oscillator (3), between said first and second reference potentials (4, 5).

2. Device according to claim 1, **characterized in that** the voltage follower/amplifier device (1) comprises an operational amplifier.

3. Device according to one of claims 1 or 2, **characterized in that** it comprises moreover a voltage divider inserted between the oscillator (3) and the input of the voltage follower/amplifier device (1).

4. Device according to claim 3, **characterized in that** it comprises moreover at least one resistor (7) inserted between the oscillator (3) and the input of the voltage follower/amplifier device (1), and at least one resistor (8) inserted between the input of the voltage follower/amplifier device (1) and the second reference potential (5).

5. Device according to one of the preceding claims, **characterized in that** it comprises moreover power supply transfer means (21) able to generate, at a power supply output (22), an electrical power supply (**Vf**) referenced to the first reference potential (4), from a primary power supply source (20) referenced to the second reference potential (5).

6. Device according to claim 5, **characterized in that** it comprises moreover an electric circuit connecting the terminals of the primary power supply source (20) through the output of the voltage follower/amplifier device (1).

7. Device according to one of claims 5 or 6, **characterized in that** it comprises moreover power supply transfer means (21) arranged as a voltage raising chopper device, comprising:

   - an inductance (40) connected to a primary substantially DC power supply source (20),
   - a switch (41) connected, respectively, to the inductance (40) and to the second reference potential (5), so as to be able to open and close the circuit in a cyclic manner,

   - a diode (21) connected, respectively, to the inductance (40) and to a power supply output (22), and
   - filtering means (43), comprising at least one filtering capacitor (43) connected to the power supply output (22) and to the first reference potential (4), respectively.

8. Device according to one of claims 5 or 6, **characterized in that** it comprises moreover power supply transfer means (21) arranged as a voltage-raising rectifier, comprising:

   - a load capacitor (50) connected to a bipolar alternating primary power supply source (20),
   - a first diode (51) connected, respectively, to the first reference potential (4) and to the load capacitor (50),
   - a second diode (52) connected, respectively, to the load capacitor (50) and to the power supply output (22), and
   - filtering means comprising at least one filtering capacitor (53) connected to the power supply output (22) and to the first reference potential (4), respectively.

9. Device according to one of the preceding claims, **characterized in that** it is produced according to integrated electronics technologies.

10. Electronic capacitive measuring system comprising a first subsystem (D1) electrically referenced to a guard potential (4), a second subsystem (D2) electrically referenced to a ground potential (5), and an oscillator (3) referenced to said guard potential (4), **characterized in that** it comprises moreover a device according to any one of the preceding claims for imposing between said ground (5) and guard (4) potentials an alternating voltage difference (Vo) which depends on the signal generated by the oscillator (3).

11. Electronic capacitive measuring system according to claim 10, **characterized in that** it comprises moreover a charge amplifier (13) referenced to the guard potential (4) and supplied by power supply transfer means (21) according to any one of claims 5 to 9.

12. Method for generating an alternating voltage difference (**Vo**) between a first and a second reference potential (4, 5), comprising a step of generation of a signal by means of an oscillator (3) electrically referenced to the first reference potential (4), **characterized in that** it comprises moreover a step of amplification of said signal, by means of a voltage follower/amplifier device (1) electrically referenced to the second reference potential (5) and having an input connected to the oscillator (3) and an output connected to the first reference potential (4), in such a way as to impose an alternating voltage difference (**Vo**), which depends on the signal generated by the oscillator (3), between said first and second reference potentials (4, 5).

Art antérieur

Figure 1

Figure 2

Figure 3

Figure 4

Figure 5

Figure 6

Figure 7

## RÉFÉRENCES CITÉES DANS LA DESCRIPTION

**Documents brevets cités dans la description**

- FR 2756048